# EUROPEAN PATENT APPLICATION

(11) **EP 2 755 292 A1**
(43) Date of publication of application: **16.07.2014**
(21) Application number: 12830788.1
(22) Date of filing: 29.05.2012
(51) Int. Cl.: H02J 3/38, G01R 19/14

(54) **DISTRIBUTED POWER GENERATION SYSTEM AND METHOD FOR OPERATING SAME**

(30) Priority: 09.09.2011 JP 2011196828
(71) Applicant: Panasonic Corporation, Kadoma-shi, Osaka 571-8501 (JP)
(72) Inventor: SATO, Keiichi, Osaka 540-6207 (JP); KATOU, Motomichi, Osaka 540-6207 (JP); KAKU, Hiroaki, Osaka 540-6207 (JP); KAKE, Nin, Osaka 540-6207 (JP); NAGASATO, Hiroshi, Osaka 540-6207 (JP)
(74) Representative: Grünecker, Kinkeldey, Stockmair & Schwanhäusser
(86) International application number: PCT/JP2012/003499
(87) International publication number: WO 2013/035224

(57) **Abstract**

A distributed power generation system according to the present invention is connected to a power line (33) connecting a commercial power supply (21) and an electrical load (24). On the power line (33), a second power generator (29) is connected between the commercial power supply (21) and a first connection point (23). The distributed power generation system includes: an inverter (25) connected to the first connection point (23); a first power generator (27); a current sensor (22) provided on the power line (33) between the commercial power supply (21) and the first connection point (23); and a controller (26). In a case where a current flowing in a direction from the first connection point (23) to the commercial power supply (21) is a positive current, in a state where the inverter (25) is disconnected, the controller (26) determines that there is an abnormality in an installation of the current sensor (22), or gives a notification of the abnormality in the installation of the current sensor (22), if differential power that is obtained by subtracting power consumed by the electrical loan (24) from output power of the inverter (25) is greater than a first threshold greater than 0.

## Description

### Technical Field

The present invention relates to a distributed power generation system interconnected with a commercial power supply, and to a method of operating the distributed power generation system.

### Background Art

In recent years, household distributed power generators have started to become popular as the public awareness of environmental protection has been growing. Examples of the distributed power generators include solar power generators and fuel cell power generation systems. Previously, such distributed power generators were installed in homes such that only one (type of) distributed power generator was installed in each home. However, as the public awareness of environmental protection has been growing, some households have started to install two different types of distributed power generators in their homes. For example, there are an increasing number of homes capable of so-called double power generation. Double power generation is to install both of a solar power generator and a fuel cell power generation system in one household, and generate electric power with these two types of distributed power generators.

In relation to such power generation using two types of distributed power generators, there is a known power distribution system intended to distribute AC power and DC power efficiently and improve power efficiency (see Patent Literature 1, for example). Fig. 6 is a schematic diagram showing a schematic configuration of the power distribution system disclosed in Patent Literature 1.

As shown in Fig. 6, in the power distribution system disclosed in Patent Literature 1, a fuel cell 111 and a solar cell 101 are connected to a power line 102 connecting a system power supply and an AC load (e.g., a household electrical load). Specifically, the fuel cell 111 is connected to a first connection point 105 of the power line 102 via a power line 106. The solar cell 101 is connected to a second connection point 107 of the power line 102 via a power line 108.

A power conditioner 112 is provided on the power line 106. The power conditioner 112 converts DC power generated by the fuel cell 111 into AC power, and supplies the AC power to the AC load. A power conditioner 103 is provided on the power line 108. The power conditioner 103 converts DC power generated by the solar cell 101 into AC power, and causes a reverse power flow to the system power supply or supplies the AC power to the AC load.

A first current sensor 104a is provided on the power line 102 between the first connection point 105 and the second connection point 107. On the power line 108, a second current sensor 104b is provided closer to the second connection point 107 than the power conditioner 103. An output controller 113 controls the power conditioner 112 based on current values detected by the first current sensor 104a and the second current sensor 104b.

### Citation List

### Patent Literature

PTL 1: Japanese Laid-Open Patent Application Publication No. 2010-41886

### Summary of Invention

### Technical Problem

In the power distribution system disclosed in Patent Literature 1, there is a precondition that the first current sensor 104a is disposed on the power line 102 between the first connection point 105 and the second connection point 107.

However, when installation work or maintenance work of the fuel cell 111 is performed with the solar cell 101 already installed at the work site, there have been some cases where the first current sensor 104a ends up being installed at an improper position, for example, between the system power supply and the second connection point 107 on the power line 102. In such a case, there arises a problem that electric power used by the AC load cannot be precisely detected by the first current sensor 104a.

The present invention has been made to solve the above conventional problem. An object of the present invention is to provide a distributed power generation system with a simple configuration, which is capable of determining whether a current sensor is installed properly.

### Solution to Problem

In order to solve the above-described problem, a distributed power generation system according to the present invention is configured as follows. The distributed power generation system is connected to a power line connecting a commercial power supply and an electrical load, the power line including a first connection point such that, on the power line, a second power generator is connected between the commercial power supply and the first connection point. The distributed power generation system includes: an inverter connected to the first connection point; a first power generator configured to supply electric power to the inverter; a current sensor provided on the power line between the commercial power supply and the first connection point; and a controller. In a case where a current flowing in a direction from the first connection point to the commercial power supply is a positive current, in a state where a connection between the inverter and the power line is disconnected, the controller determines that there is an abnormality in an installation state of the current sensor, or gives a notification ofthe abnormality in the installation state of the current sensor, if differential power that is obtained by subtracting power consumed by the electrical load from output power of the inverter is greater than a first threshold greater than 0.

The above configuration makes it possible to determine the installation state of the current sensor.

The above-described object, other objects, features, and advantages of the present invention will be made clear by the following detailed description of preferred embodiments with reference to the accompanying drawings.

### Advantageous Effects of Invention

The distributed power generation system and a method of operating the same according to the present invention make it possible to determine the installation state of the current sensor.

### Brief Description of Drawings

[Fig. 1] Fig. 1 is a schematic diagram showing a schematic configuration of a distributed power generation system according to Embodiment 1.
[Fig. 2] Fig. 2 is a schematic diagram showing a state where a current sensor is installed at an improper position in a distributed power generation system.
[Fig. 3] Fig. 3 is a flowchart showing the determination of the installation state of the current sensor by a controller of the distributed power generation system according to Embodiment 1.
[Fig. 4] Fig. 4 is a flowchart showing the determination ofthe installation state of the current sensor by the controller of a distributed power generation system according to Embodiment 2.
[Fig. 5] Fig. 5 is a schematic diagram showing a schematic configuration of a distributed power generation system according to Embodiment 3.

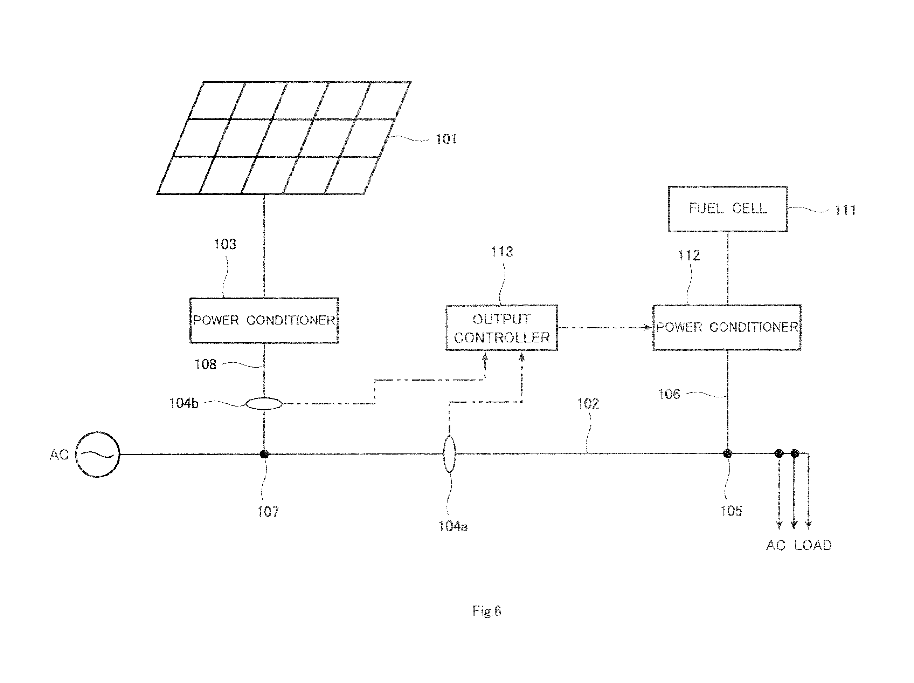

[Fig. 6] Fig. 6 is a schematic diagram showing a schematic configuration of a power distribution system disclosed in Patent Literature 1.

### Description of Embodiments

Hereinafter, preferred embodiments of the present invention are described with reference to the drawings. In the drawings, the same or corresponding components are denoted by the same reference signs, and repeating the same descriptions is avoided below. In the drawings, components necessary for describing the present invention are shown, and the other components are omitted in some cases. Further, the present invention is not limited by the embodiments below.

### (Embodiment 1)

A distributed power generation system according to Embodiment 1 serves as an example, in which the distributed power generation system is connected to a power line connecting a commercial power supply and an electrical load, the power line including a first connection point such that, on the power line, a second power generator is connected between the commercial power supply and the first connection point. The distributed power generation system includes: an inverter connected to the first connection point; a first power generator configured to supply electric power to the inverter; a current sensor provided on the power line between the commercial power supply and the first connection point; and a controller. In a case where a current flowing in a direction from the first connection point to the commercial power supply is a positive current, in a state where a connection between the inverter and the power line is disconnected, the controller determines that there is an abnormality in an installation state of the current sensor, or gives a notification of the abnormality in the installation state of the current sensor, if differential power that is obtained by subtracting power consumed by the electrical load from output power of the inverter is greater than a first threshold greater than 0.

It should be noted that while the first power generator is in preparation for supplying electric power to the inverter (i.e., during a start-up of the first power generator), the connection between the inverter and the power line is disconnected. Therefore, the "state where a connection between the inverter and the power line is disconnected" includes a state where the start-up of the first power generator is being performed.

The distributed power generation system according to Embodiment 1 may further include a display device configured to change a content to display based on information transmitted from the controller. The controller may cause the display device to display the abnormality in the installation state of the current sensor if the differential power is greater than the first threshold. It should be noted that, for example, the notification of the abnormality in the installation state of the current sensor may be directly given to a maintenance service company, or the notification of the abnormality may be given by siren, or the abnormality may be announced by a speaker or the like.

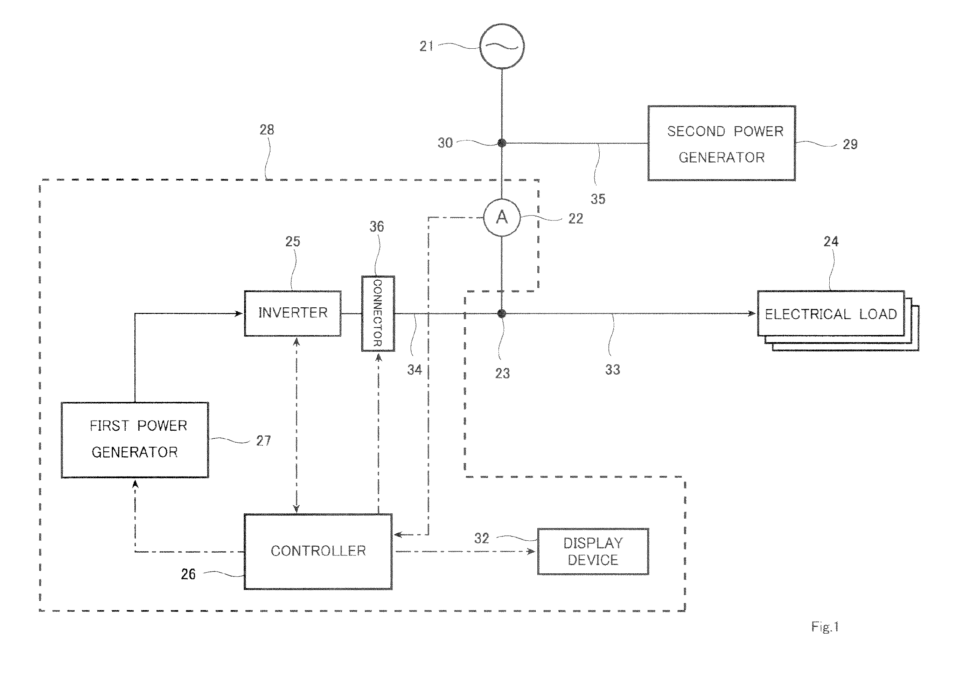

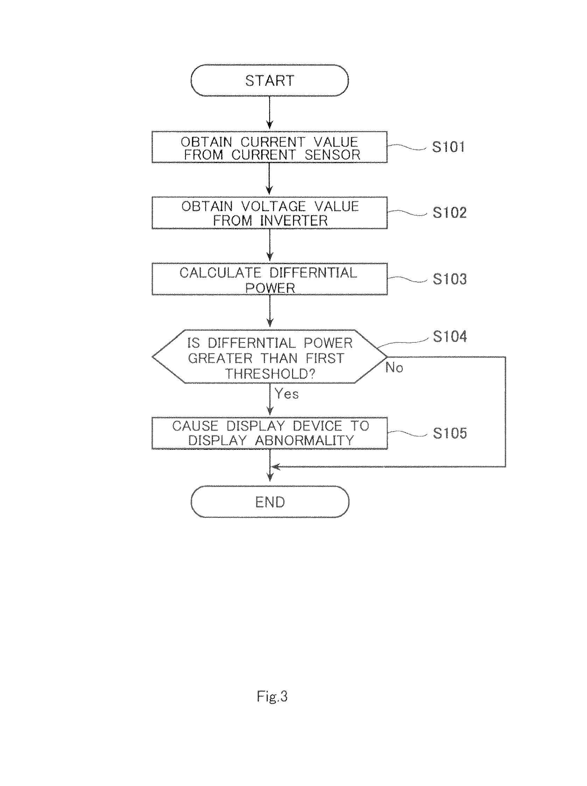

Hereinafter, one example of the distributed power generation system according to Embodiment 1 is described in detail with reference to Fig. 1. to Fig. 3.

### [Configuration of Distributed Power Generation System]

Fig. 1 is a schematic diagram showing a schematic configuration of the distributed power generation system according to Embodiment 1. Fig. 1 shows a state where a current sensor is installed at a proper position.

As shown in Fig. 1, a distributed power generation system 28 according to Embodiment 1 is connected to a power line 33 connecting a commercial power supply 21 and an electrical load 24. The power line 33 is a single-phase two-wire line or a single-phase three-wire line. On the power line 33, a second power generator 29 is connected between the commercial power supply and a first connection point 23. Specifically, the second power generator 29 is connected to a second connection point 30 of the power line 33 via a power line 35. It should be noted that the second power generator 29 is a power generator configured to generate electric power utilizing natural energy such as solar light, wind power, solar heat, etc. The electrical load 24 is a household apparatus configured to consume electric power, for example, a washing machine, an air conditioner, or a refrigerator.

The distributed power generation system 28 includes a current sensor 22, an inverter 25, a controller 26, a first power generator 27, and a display device 32. The first power generator 27 is connected to the first connection point 23 of the power line 33 via a power line 34. A connector 36 and the inverter 25 are provided on the power line 34.

The first power generator 27 is a power generator configured to generate electric power by using a fossil fuel. Examples of the first power generator 27 include power generation units such as a fuel cell and a gas turbine. The inverter 25 is configured to convert DC power generated by the first power generator 27 into AC power, and supply the AC power to the electrical load 24. The connector 36 is configured to connect/disconnect between the inverter 25 and the power line 34 (power line 33). The connector 36 is, for example, a relay. It should be noted that the inverter 25 is configured to detect a voltage value of the power line 34 (power line 33).

The current sensor 22 is provided on the power line 33 between the first connection point 23 and the second connection point 30. Specifically, the current sensor 22 is installed in a distribution board of a consumer, which is not shown. The current sensor 22 is configured to detect the magnitude and direction of a current flowing through the power line 33. Specifically, in a case where a current flowing in a direction from the first connection point 23 (electrical load 24) to the commercial power supply 21 is a positive current, the current sensor 22 is configured to detect the magnitude and direction of a current (a current value) flowing through the power line 33, and output the detected current value to the controller 26. The current sensor 22 is a clamp-type alternating current sensor, for example.

The controller 26 may be configured as any device, so long as the device is configured to control the distributed power generation system 28. The controller 26 includes: an arithmetic processing unit exemplified by, for example, a microprocessor or a CPU; and a storage unit configured as a memory or the like storing programs for performing control operations. Through loading and execution, by the arithmetic processing unit, of a predetermined control program stored in the storage unit, the controller 26 performs various control of the distributed power generation system 28, for example, control of the power generation by the first power generator 27 and control of output power of the inverter 25.

The controller 26 is configured such that, if differential power that is obtained by subtracting power consumed by the electrical load 24 from the output power of the inverter 25 is greater than a first threshold greater than 0, the controller 26 determines that there is an abnormality in the installation state of the current sensor 22, or gives a notification of the abnormality in the installation state of the current sensor 22. In Embodiment 1, the controller 26 is configured to cause the display device 32 to display the abnormality in the installation state of the current sensor 22. The determination of the installation state of the current sensor 22 will be described below.

It should be noted that the controller 26 may be configured not only as a single controller, but as a group of multiple controllers that operate in cooperation with each other to control the distributed power generation system 28. Moreover, the controller 26 may be configured as a microcontroller. Furthermore, the controller 26 may be configured as an MPU, PLC (Programmable Logic Controller), logic circuit, or the like.

The display device 32 may be configured in any form, so long as the display device 32 is configured to display information (character data, image data, etc.) outputted from the controller 26.

For example, a remote controller, mobile phone, smartphone, or a tablet computer may be used as the display device 32. The display device 32 may include operating units such as switches, a display unit such as an LCD screen, or an announcing unit such as a speaker.

### [Operation of Distributed Power Generation System]

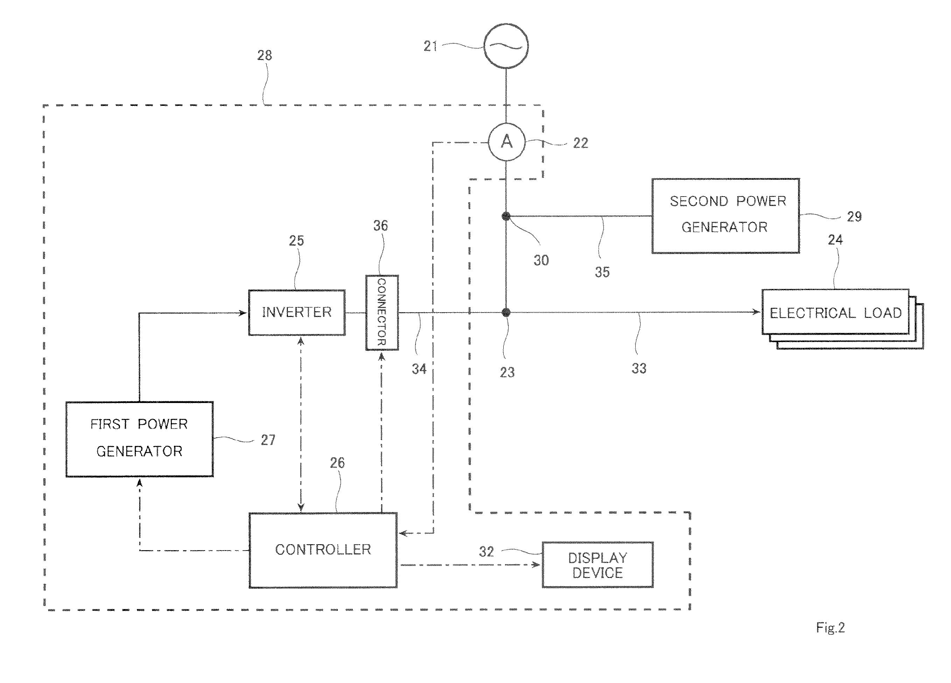

First, the installation position of the current sensor 22 is described with reference to Fig. 1 and Fig. 2.

Fig. 2 is a schematic diagram showing a state where the current sensor is installed at an improper position in a distributed power generation system.

The distributed power generation system 28 shown in Fig. 2 includes the same component devices as those of the distributed power generation system 28 shown in Fig. 1, but is different from the distributed power generation system 28 shown in Fig. 1 in the following point: in the distributed power generation system 28 shown in Fig. 2, the current sensor 22 is provided on the power line 33 between the commercial power supply 21 and the second connection point 30.

Assume a case where: the current sensor 22 has detected -1.0 A; the connection between the inverter 25 and the power line 34 (power line 33) is disconnected (the output power of the inverter 25 is 0 W); and the inverter 25 has detected a voltage value of 100 V. In this case, if the current sensor 22 is provided at the proper position as shown in Fig. 1, it means that electric power of 100 W is being supplied to the electrical load 24 from the commercial power supply 21 and/or the second power generator 29, and electric power that is being consumed by the electrical load 24 is 100 W. In this case, if a current sensor is further provided on the power line 35 as in the power distribution system disclosed by Patent Literature 1, the electric power supplied to the electrical load 24 from the commercial power supply 21 and/or the second power generator 29 can be calculated (obtained). For example, if the current sensor provided on the power line 35 has detected 0.0 A, it means that electric power of 100 W is being supplied to the electrical load 24 from the commercial power supply 21. if the current sensor provided on the power line 35 has detected 1.0 A, it means that the second power generator 29 is generating electric power of 100 W.

Meanwhile, in a case where the current sensor 22 is provided at an improper position as shown in Fig. 2, if electric power that is being generated by the second power generator 29 is unknown, then electric power that is being consumed by the electrical load 24 is also unknown. Even if a current sensor is further provided on the power line 35 as in the power distribution system disclosed by Patent Literature 1, the electric power that is being consumed by the electrical load 24 is still unknown for the reason described below.

Specifically, in the case where the current sensor 22 is disposed at the position shown in Fig. 2, if the current sensor 22 detects -1.0 A similar to the above-described case and the second power generator 29 is not generating electric power, then the current value detected by the current sensor provided on the power line 35 is 0.0 A and the electric power that is being consumed by the electrical load 24 is 100 W. Here, if the second power generator 29 is generating electric power of 100 W, then the current value detected by the current sensor provided on the power line 35 is 1.0 A and the electric power that is being consumed by the electrical load 24 is 200 W.

As described above, when the current sensor 22 is disposed at an improper position, even if the current sensor 22 detects the same values, the actual electric power consumed by the electrical load 24 may vary. Therefore, for the control of the distributed power generation system 28, it is important that the controller 26 determines whether the current sensor 22 is disposed at a proper position.

Next, the determination of the installation state of the current sensor 22 by the controller 26 of the distributed power generation system 28 according to Embodiment 1 is described with reference to Fig. 1 to Fig. 3.

Fig. 3 is a flowchart showing the determination of the installation state of the current sensor by the controller of the distributed power generation system according to Embodiment 1.

As shown in Fig. 3, the controller 26 obtains, from the current sensor 22, a current value detected by the current sensor 22 (step S101). Then, the controller 26 obtains, from the inverter 25, the voltage value of a voltage currently applied to the power line 34 (power line 33) (step S102).

Next, based on the current value obtained in step S101 and the voltage value obtained in step S 102, the controller 26 calculates differential power by subtracting power consumed by the electrical load 24 from output power of the inverter 25 (step S103), and determines whether the differential power is greater than the first threshold (step S104). It should be noted that, in Embodiment 1, the inverter 25 is not connected to the power line 34 (power line 33). Accordingly, the output power of the inverter 25 is 0 W.

The first threshold herein indicates electric power greater than 0. If the distributed power generation system 28 is configured such that a reverse power flow from the distributed power generation system 28 is prevented, then based on system interconnection deliberation with a power company (i.e., an agreement on interconnection with the commercial power supply 21), the first threshold may be set to any electric power value greater than 50 W which is a predetermined setting value. The first threshold may be set to 300 W, for example.

If the differential power calculated in step S103 is greater than the first threshold (Yes in step S104), the controller 26 causes the display device 32 to show a display indicating abnormal installation of the current sensor 22 (step S105), and ends the flow. On the other hand, if the differential power calculated in step S 103 is not greater than the first threshold (No in step S104), the controller 26 ends the flow since the current sensor 22 is installed at a proper position.

As described above, the distributed power generation system 28 according to Embodiment 1 is capable of determining the installation state of the current sensor 22. If there is an abnormality in the installation state of the current sensor 22, the display device 32 displays the abnormality to notify the user of the abnormality, making it possible to start maintenance work at an early stage.

### [Variation 1]

Next, a variation ofthe distributed power generation system according to Embodiment 1 is described.

A distributed power generation system according to Variation 1 of Embodiment 1 serves as an example in which, in a state where the first power generator stops electric power generation, the controller determines that there is an abnormality in the installation state of the current sensor, or gives a notification of the abnormality in the installation state of the current sensor, if the differential power is greater than the first threshold. It should be noted that the configuration of the distributed power generation system 28 according to Variation 1 is the same as that of the distributed power generation system 28 according to Embodiment 1. Therefore, the description of the configuration of the distributed power generation system 28 according to Variation 1 is omitted.

In the distributed power generation system 28 according to Variation 1, in a state where the first power generator 27 stops electric power generation, the controller 26 determines the installation state of the current sensor in accordance with the flow shown in Fig. 3. The "state where the first power generator 27 stops electric power generation" herein includes a state where the first power generator 27 is performing a stop operation, and also includes a state where the first power generator 27 has ended the stop operation but the first power generator 27 has not yet started a start-up operation. Accordingly, the state where the first power generator 27 stops includes a state where some of the component devices of the first power generator 27 are still in operation.

The distributed power generation system 28 according to Variation 1 with the above-described feature provides the same operational advantages as those provided by the distributed power generation system 28 according to Embodiment 1.

### (Embodiment 2)

A distributed power generation system according to Embodiment 2 serves as an example in which, in a case where the first power generator is configured such that a reverse power flow from the first power generator to the commercial power supply is prevented, and the second power generator is configured such that a reverse power flow from the second power generator to the commercial power supply is allowed, the controller prohibits the first power generator from performing a start-up if the differential power is greater than the first threshold, and the controller allows the first power generator to perform a start-up if the differential power is not greater than the first threshold.

The definition of "prohibits the first power generator from performing a start-up" includes not only prohibiting a start-up of the first power generator from its standby state (i.e., not only refraining from starting a start-up of the first power generator), but also stopping a start-up operation of the first power generator when the start-up operation is already in progress.

The configuration of the distributed power generation system 28 according to Embodiment 2 is the same as that of the distributed power generation system 28 according to Embodiment 1. Therefore, the description of the configuration of the distributed power generation system 28 according to Embodiment 2 is omitted.

### [Operation of Distributed Power Generation System]

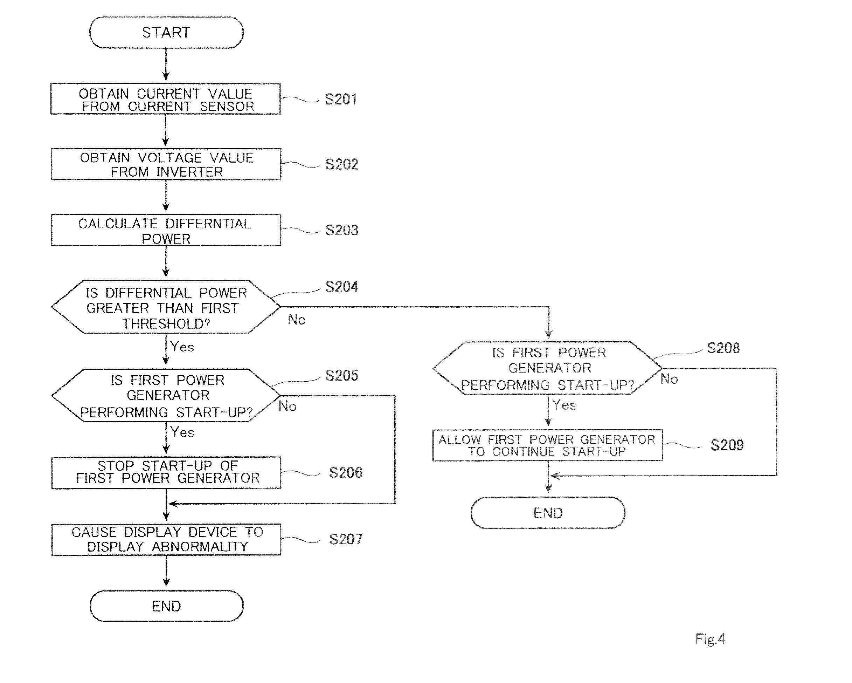

Fig. 4 is a flowchart showing the determination of the installation state of the current sensor by the controller of the distributed power generation system according to Embodiment 2.

As shown in Fig. 4, the controller 26 obtains, from the current sensor 22, a current value detected by the current sensor 22 (step S201). Then, the controller 26 obtains, from the inverter 25, the voltage value of a voltage applied to the power line 34 (power line 33) (step S202).

Next, based on the current value obtained in step S201 and the voltage value obtained in step S202, the controller 26 calculates differential power by subtracting power consumed by the electrical load 24 from output power of the inverter 25 (step S203), and determines whether the differential power is greater than the first threshold (step S204). Also in Embodiment 2, the output power of the inverter 25 is 0 W since the inverter 25 is not connected to the power line 34 (power line 33).

If the differential power calculated in step S203 is greater than the first threshold (Yes in step S204), the controller 26 advances the flow to step S205. If the differential power calculated in step S203 is not greater than the first threshold (No in step S204), the controller 26 advances the flow to step S208. It should be noted that operations in step S208 and thereafter will be described below.

In step S205, the controller 26 determines whether the first power generator 27 is currently performing a start-up. If the first power generator 27 is currently performing a start-up (Yes in step S205), the controller 26 stops (prohibits) the start-up of the first power generator 27 (step S206), and causes the display device 32 to show a display indicating abnormal installation of the current sensor 22 (step S207). Then, the controller 26 ends the flow.

If the first power generator 27 is not currently performing a start-up (No in step S205), the controller 26 causes the display device 32 to show a display indicating abnormal installation of the current sensor 22 (step S207), and ends the flow.

Also in a case where the differential power calculated in step S203 is not greater than the first threshold (No in step S204), the controller 26 determines whether the first power generator 27 is currently performing a start-up (step S208).

If the first power generator 27 is currently performing a start-up (Yes in step S208), the controller 26 allows the first power generator 27 to continue the start-up since the current sensor 22 is installed at a proper position (step S209). Then, the controller 26 ends the flow. On the other hand, if the first power generator 27 is not currently performing a start-up (No in step S205), the controller 26 ends the flow.

As described above, the distributed power generation system 28 according to Embodiment 2 with the above-described feature is capable of determining the installation state of the current sensor 22. The distributed power generation system 28 according to Embodiment 2 is configured to stop (prohibit) the start-up of the first power generator 27 when the installation position of the current sensor 22 is determined to be abnormal, thereby making it possible to suppress wasteful consumption of, for example, a raw material.

It should be noted that, alternatively, when the differential power calculated in step S 103 is greater than the first threshold, the controller 26 may stop (prohibit) the start-up of the first power generator 27 after causing the display device 32 to display an abnormality.

### (Embodiment 3)

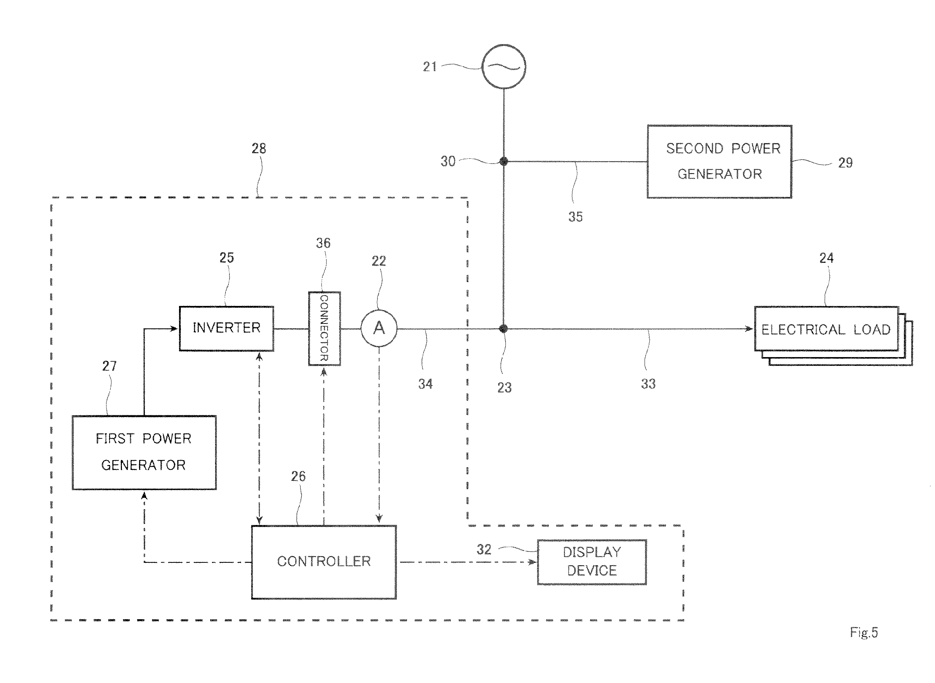

Fig. 5 is a schematic diagram showing a schematic configuration of a distributed power generation system according to Embodiment 3.

As shown in Fig. 5, the fundamental configuration of the distributed power generation system 28 according to Embodiment 3 is the same as that of the distributed power generation system 28 according to Embodiment 1. However, the distributed power generation system 28 according to Embodiment 3 is different from the distributed power generation system 28 according to Embodiment 1 in terms of the position where the current sensor 22 is disposed. Specifically, the current sensor 22 is provided on the power line 34.

The distributed power generation system 28 according to Embodiment 3 with the above configuration provides the same operational advantages as those provided by the distributed power generation system 28 according to Embodiment 1.

From the foregoing description, numerous modifications and other embodiments of the present invention are obvious to one skilled in the art. Therefore, the foregoing description should be interpreted only as an example and is provided for the purpose of teaching the best mode for carrying out the present invention to one skilled in the art. The structural and/or functional details may be substantially altered without departing from the spirit of the present invention. In addition, various inventions can be made by suitable combinations of a plurality of components disclosed in the above embodiments.

### Industrial Applicability

The distributed power generation system and the method of operating the same according to the present invention are useful since they are capable of determining the installation state of the current sensor.

### Reference Signs List

- 21: commercial power supply
- 22: current sensor
- 23: first connection point
- 24: electrical load
- 25: inverter
- 26: controller
- 27: first power generator
- 28: distributed power generation system
- 29: second power generator
- 30: second connection point
- 31: third connection point
- 32: display device
- 33: power line
- 34: power line
- 35: power line
- 36: connector
- 101: solar cell
- 102: power line
- 103: power conditioner
- 104a: first current sensor
- 104b: second current sensor
- 105: first connection point
- 106: power line
- 107: second connection point
- 108: power line
- 111: fuel cell
- 112: power conditioner
- 113: output controller

## Claims

1. A distributed power generation system connected to a power line connecting a commercial power supply and an electrical load, the power line including a first connection point such that, on the power line, a second power generator is connected between the commercial power supply and the first connection point, the distributed power generation system comprising:
an inverter connected to the first connection point;
a first power generator configured to supply electric power to the inverter;
a current sensor provided on the power line between the commercial power supply and the first connection point; and
a controller, wherein
in a case where a current flowing in a direction from the first connection point to the commercial power supply is a positive current,
in a state where a connection between the inverter and the power line is disconnected, the controller determines that there is an abnormality in an installation state of the current sensor, or gives a notification of the abnormality in the installation state of the current sensor, if differential power that is obtained by subtracting power consumed by the electrical load from output power of the inverter is greater than a first threshold greater than 0.

2. The distributed power generation system according to claim 1, wherein
in a case where the first power generator is configured such that a reverse power flow from the first power generator to the commercial power supply is prevented, and the second power generator is configured such that a reverse power flow from the second power generator to the commercial power supply is allowed,
the controller prohibits the first power generator from performing a start-up if the differential power is greater than the first threshold, and
the controller allows the first power generator to perform a start-up if the differential power is not greater than the first threshold.

3. The power generation system according to claim 1 or claim 2, wherein
in a state where the first power generator stops electric power generation, the controller determines that there is an abnormality in the installation state of the current sensor, or gives a notification of the abnormality in the installation state ofthe current sensor, if the differential power is greater than the first threshold.

4. The distributed power generation system according to any one of claims 1 to 3, further comprising a display device configured to change a content to display based on information transmitted from the controller, wherein
the controller causes the display device to display the abnormality in the installation state of the current sensor if the differential power is greater than the first threshold.

5. A method of operating a distributed power generation system connected to a power line connecting a commercial power supply and an electrical load, the power line including a first connection point such that, on the power line, a second power generator is connected between the commercial power supply and the first connection point,
the distributed power generation system including:
an inverter connected to the first connection point;
a first power generator configured to supply electric power to the inverter;
a current sensor provided on the power line between the commercial power supply and the first connection point; and
a controller,
the method comprising, in a case where a current flowing in a direction from the first connection point to the commercial power supply is a positive current and in a state where a connection between the inverter and the power line is disconnected, determining by the controller that there is an abnormality in an installation state of the current sensor, or giving by the controller a notification of the abnormality in the installation state of the current sensor, if differential power that is obtained by subtracting power consumed by the electrical load from output power of the inverter is greater than a first threshold greater 0.
